# EUROPEAN PATENT APPLICATION

(11) **EP 1 394 284 A1**
(43) Date of publication of application: **03.03.2004**
(21) Application number: 02700587.5
(22) Date of filing: 15.02.2002
(51) Int. Cl.: C23C 14/34, G11B 7/24, G11B 7/26

(54) **SPUTTERING TARGET FOR FORMING PHASE CHANGE OPTICAL DISC PROTECTIVE FILM AND OPTICAL RECORDING MEDIUM HAVING PHASE CHANGE OPTICAL DISC PROTECTIVE FILM FORMED USING THAT TARGET**

(30) Priority: 01.06.2001 JP 2001166246
(71) Applicant: Nikko Materials Company, Limited, Tokyo 105-8407 (JP)
(72) Inventor: YAHAGI, Masataka, c/o Isohara Factory of Nikko, Kitaibaraki-shi, Ibaraki 319-1535 (JP); TAKAMI, Hideo, c/o Isohara Factory of Nikko, Kitaibaraki-shi, Ibaraki 319-1535 (JP)
(74) Representative: Meddle, Alan Leonard
(86) International application number: PCT/JP2002/001306
(87) International publication number: WO 2002/099156

(57) **Abstract**

The present invention relates to a sputtering target for forming a phase change optical disc protective film formed from a complex of chalcogenide and silicic oxide, characterized in that the sputtering target for forming a phase change optical disc protective film has, at least in the erosion portion, a texture which becomes 0.3 ≤ A/B ≤ 0.95 when the average length of silicic oxide in the normal line direction existing on the face within the range of -30°∼+30° against the normal line direction of the sputtering face is given as A and the average length in the vertical direction against the normal line is given as B. Obtained is a sputtering target formed from a complex of chalcogenide and silicic oxide capable of suppressing nodules, increasing the evenness of deposition, and improving the productivity, and which is effective in forming a phase change optical disc protective film, as well as an optical recording medium having formed thereon the phase change optical disc protective film using such a target.

## Description

### Technical Field

The present invention relates to a sputtering target formed from a complex of chalcogenide and silicic oxide capable of reducing particles (dust emission) and nodules produced during sputtering upon forming a film with sputtering, which is of high density and having minimal variation in quality, capable of improving mass productiveness, and, in particular, which is effective in forming a phase change optical disc protective film, as well as to an optical recording medium having formed thereon the phase change optical disc protective film using such a target.

### Background Art

In recent years, high-density recordable optical disc technology capable of recording/reading (playing) without requiring a magnetic head has been developed, and is rapidly attracting attention. This optical disc can be classified into the three categories of read-only, write-once and rewritable. Particularly, the phase change method employed in the rewritable type discs is attracting attention. The fundamental principle of the recording/reading (playing) employing this phase change optical disc is briefly described below.

This phase change optical disc performs the recording/ reading (playing) of information by heating and increasing the temperature of a recording thin film on a substrate by irradiating a laser beam thereto, and generating a crystallographic phase change (amorphous ⇔ crystal) in the structure of such recording thin film. More specifically, the reading (playing) of information is conducted by detecting the change in the reflectivity caused by the change in the optical constant of the phase.

The aforementioned phase change is performed with the irradiation of a laser beam narrowed down to a diameter of approximately 1 to several µm. Here, for example, when a 1 µm laser beam passes through at a linear velocity of 10m/s, light is irradiated to a certain point on the optical disc for 100ns, and it is necessary to perform the aforementioned phase change and detect the reflectivity within such time frame.

Moreover, in order to realize the foregoing crystallographic phase change; that is, the phase change of the amorphous and crystal, not only will the phase change recording layer be added to fusion and quenching more than once, the peripheral dielectric protective layer and aluminum alloy will also be repeatedly added thereto.

In light of the above, a phase change optical disc has a four-layer structure wherein, for instance, both sides of a Ge-Sb-Te recording thin film layer or the like are sandwiched with a ZnS ^{·} SiO₂ high-melting point dielectric or the like, and an aluminum alloy reflective layer is additionally provided thereto.

Among the above, in addition to being demanded of an optical function capable of increasing the absorption of the amorphous portion and crystal portion and which has a large reflectivity difference, the reflective layer and protective layer are also demanded of a function for preventing the deformation caused by the moisture resistance or heat of the recording thin film as well as a function for controlling the thermal conditions upon recording (c.f. "*Kogaku*" magazine, volume 26, no. 1, pages 9 to 15).

As described above, the protective layer of a high-melting point dielectric must be durable against repeated thermal stress caused by the heating and cooling, must not allow such thermal effect to influence the reflective film or other areas, and it is also required to be thin, of low reflectivity, and possess strength to prevent deterioration. From this perspective, the dielectric protective layer plays an important role.

The dielectric protective layer described above is usually formed with the sputtering method. This sputtering method makes a positive electrode substrate and a negative electrode target face each other, and generates an electric field by applying a high voltage between the substrates thereof and the targets under an inert gas atmosphere. The sputtering method employs a fundamental principle where plasma is formed pursuant to the collision of electrons, which are ionized at such time, and the inert gas, the positive ion in this plasma extrudes the atoms structuring the target by colliding with the target (negative electrode) surface, and the extruded atoms adhere to the opposing substrate surface, wherein the film is formed thereby.

Conventionally, since the aforementioned protective layer is demanded of permeability, heat resistance, and so on in a visible light, sputtering is conducted with a target formed from a complex of chalcogenide and silicic oxide such as ZnS-SiO₂ or the like (explanation will hereinafter be made with the representative example of ZnS-SiO₂ unless a specific name of a substance is indicated) in order to form a thin film of approximately 500 to 2000Å.

These materials are deposited with a radio-frequency sputtering (RF) device, a magnetron-sputtering device, or with a DC (direct current) sputtering device upon conducting special processing to the target material.

The sputtering face of the target can be made even and smooth and high densification of the target formed from a complex of chalcogenide and silicic oxide, whereby yielding a characteristic of reducing particles and nodules as well as prolonging the target life. It is well known that the productivity of optical discs can be improved as a result thereof.

Nevertheless, conventionally, upon preparing a target formed from a complex of silicic oxide having chalcogenide, the reaction between chalcogenide and silicic oxide would not occur easily, nor would the deformation or the like of silicic oxide itself occur within the range of the sintering temperature of chalocogenide. Moreover, in general, silicic oxide has higher insulation when compared to chalocogenide, and, when giving consideration to the discharge stability of sputtering, desired is a target where minute silicic oxide is evenly dispersed of the chalocogenide.

Thus, this type of chalocogenide and silicic oxide target easily creates a space between the chalocogenide and silicic oxide, which becomes more noticeable when the silicic oxide is miniaturized, and, since the sintering of chalocogenide is also prevented thereby, there is a problem in that the target density will deteriorate.

In particular, the cause of particles is considered to be the space between the chalocogenide and silicic oxide, and nodules are considered to arise beginning at silicic oxide, which has a low sputtering ratio. Therefore, it is desirable that there is no space between the chalocogenide and silicic oxide, and that the silicic oxide existing continuously in the sputtering erosion direction be kept to a minimum.

### Disclosure of the Invention

An object of the present invention is to enable the stable manufacture of a target at low cost and in which the crystal grain is minute and of a high density of 97% or more, and to thereby obtain a sputtering target formed from a complex of chalcogenide and silicic oxide for forming an optical disc protective film capable of further improving the evenness of deposition and increasing the productivity rate, and an optical recording medium having formed thereon a phase change optical disc protective film upon using such target.

In order to achieve the foregoing object, as a result of intense study, the present inventors discovered that by adjusting the shape of silicic oxide and miniaturizing the same, the sputtering face of the target can be made even and smooth, high densification can be easily realized, generation of particles and nodules arising at the time of sputtering can be reduced without detriment to the characteristics as a protective film, and evenness of the film thickness can also be improved.

Based on the foregoing discovery, the present invention provides:
1. A sputtering target for forming a phase change optical disc protective film formed from a complex of chalcogenide and silicic oxide, characterized in that the sputtering target for forming a phase change optical disc protective film has, at least in the erosion portion, a texture which becomes 0.3 ≤ A/B ≤ 0.95 when the average length of silicic oxide in the normal line direction existing on the face within the range of -30°∼+30° against the normal line direction of the sputtering face is given as A and the average length in the vertical direction against the normal line is given as B.
2. A sputtering target for forming a phase change optical disc protective film, characterized in that the average length A of silicic oxide in the normal line direction existing on the face within the range of -30 °∼+30° against the normal line direction of the sputtering face is 0.1∼10µm.
3. A sputtering target for forming a phase change optical disc protective film according to paragraph 1 above, characterized in that the average length A of silicic oxide in the normal line direction existing on the face within the range of -30°∼+30° against the normal line direction of the sputtering face is 0.1∼10µm.
4. A sputtering target for forming a phase change optical disc protective film according to each of paragraphs 1 to 3 above, characterized in that the chalcogenide contains zinc sulfide.
5. A sputtering target for forming a phase change optical disc protective film according to each of paragraphs 1 to 4 above, characterized in that the composition of silicic oxide is 1∼50mol%.
6. A sputtering target for forming a phase change optical disc protective film according to each of paragraphs 1 to 5 above, characterized in that the silicic oxide is silicon dioxide having a purity of 98% or higher.
7. A sputtering target for forming a phase change optical disc protective film according to each of paragraphs 1 to 6 above, characterized in that the crystallization temperature of silicic oxide is within the range of 900∼1400°C.
8. A sputtering target for forming a phase change optical disc protective film according to each of paragraphs 1 to 7 above, characterized in that the relative density is 97% or higher.
9. An optical recording medium having formed thereon a phase change optical disc protective film upon using the sputtering target according to paragraphs 1 to 8 above.

### Brief Description of the Drawings

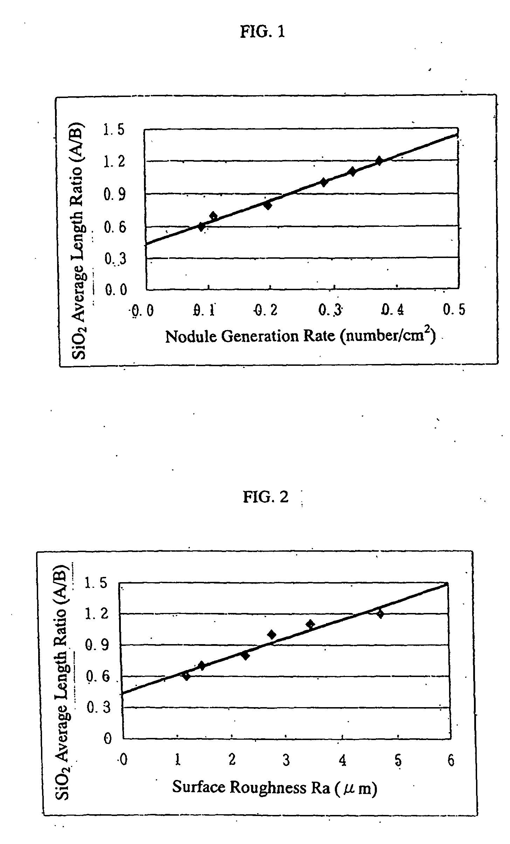

Fig. 1 is a graph showing the correlation of A/B, which is the ratio of the generation rate of nodules and the length of the SiO₂ portion, and Fig. 2 is a graph showing the correlation of A/B, which is the ratio of the surface roughness Ra (µm) and the length of the SiO₂ portion.

### Best Mode for Carrying Out the Invention

The sputtering target for forming a phase change optical disc protective film formed from a complex of chalcogenide and silicic oxide according to the present invention has a significant characteristic in that it has, at least in the erosion portion, a texture which becomes 0.3 ≤ A/B ≤ 0.95 when the average length of silicic oxide in the normal line direction existing on the face within the range of -30°∼+30° against the normal line direction of the sputtering face is given as A and the average length in the vertical direction against the normal line is given as B.

The length of silicic oxide existing on the face within the range of -30°∼+30° against the normal line direction as used herein implies a face existing in the normal line direction or within the range of -30°∼+30° diverted from such normal line direction.

In other words, by reducing the existence of SiO₂ grains existing along the thickness direction of the sputtering target; that is, by thinning and compressing the SiO₂ grains under the foregoing conditions, the generation of particles and nodules can be effectively suppressed.

Moreover, it is further effective if the average length of silicic oxide in the normal line direction existing on the face within the range of -30°∼+30° against the normal line direction of the sputtering face is 0.1∼10µm.

Further, in the sputtering target for forming a phase change optical disc protective film according to the present invention, it is desirable that the chalcogenide contains zinc sulfide, and the composition of silicic oxide is 1∼50mol%.

As the foregoing silicic oxide, silicon dioxide having a purity of 98% or higher is typically used, and it is further desirable that the crystallization temperature of silicic oxide is within the range of 900∼1400°C. The sputtering target for forming a phase change optical disc protective film according to the present invention is able to achieve a relative density of 97% or higher. The present invention includes an optical recording medium having formed thereon a phase change optical disc protective film upon using the foregoing sputtering target.

As illustrated specifically in the Examples below, the target is manufactured by evenly dispersing and mixing chalcogenide powder and silicic oxide powder, and molding this with hot pressing or the like. Obtained thereby is a sputtering target for forming a phase change optical disc protective film with not much space between the chalcogenide powder and silicic oxide powder, and which has a relative density of 97% or more.

An additive of 0.001∼5wt% of alkali metal or one or more types selected from the oxides thereof or alkali earth metal or one or more types selected from the oxides thereof would facilitate and be effective in the manufacture of the target according to the present invention. Alkali metal includes Li, Na, K, Rb, Cs and Fr; and alkali earth metal includes Be, Mg, Ca, Sr, Ba and Ra. In addition, 0.001 to 10wt% of boron, aluminum, phosphorus, arsenic or the oxides thereof may also be contained in the above.

With the target of the present invention, since the crystal grain can be miniaturized and highly densified, a significant effect is yielded in that the sputtering face of the target can be made even and smooth, particles and nodules at the time of sputtering can be reduced, and the target life can be prolonged.

As a result, the productivity of the optical recording medium of the present invention having formed thereon a phase change optical disc protective film will increase, and a material superior in quality can be obtained thereby.

### Examples and Comparative Examples

The present invention is now described with reference to the Examples and Comparative Examples. These Examples are merely illustrative, and the present invention shall in no way be limited thereby. In other words, the present invention shall only be limited by the scope of claim for a patent, and shall include the various modifications other than the Examples of this invention.

### (Example 1)

ZnS powder having a purity of 4N (99.99%) or higher and SiO₂ powder containing 0.1wt% Na₂O were used, and SiO₂ was mixed with ZnS at a ratio of 20mol%.

This mixed powder was filled in a graphite die, and hot pressed under the conditions of an Ar atmosphere, a bearing of 150kg/cm², and a temperature of 1000°C.

The target obtained thereby had a relative density of 99%. Moreover, the ratio (A/B) of the average length in the normal line direction and the average length in the vertical direction against such normal line at the SiO₂ portion of the sputtering face was 0.7, and the average length in the normal line direction of the SiO₂ portion was 8µm.

### (Example 2)

ZnS powder having a purity of 4N (99.99%) or higher and SiO₂ powder containing 0.2wt% CaO were used, and SiO₂ was mixed with ZnS at a ratio of 20mol%.

This mixed powder was filled in a graphite die, and hot pressed under the conditions of an Ar atmosphere, a bearing of 150kg/cm², and a temperature of 1000°C.

The target obtained thereby had a relative density of 98%. Moreover, the ratio (A/B) of the average length in the normal line direction and the average length in the vertical direction against such normal line at the SiO₂ portion of the sputtering face was 0.9, and the average length in the normal line direction of the SiO₂ portion was 10µm.

### (Example 3)

ZnS powder having a purity of 4N (99.99%) or higher and SiO₂ powder containing 0.2wt% K₂O were used, and SiO₂ was mixed with ZnS at a ratio of 20mol%.

This mixed powder was filled in a graphite die, and hot pressed under the conditions of an Ar atmosphere, a bearing of 150kg/cm², and a temperature of 1100°C.

The target obtained thereby had a relative density of 99.5%. Moreover, the ratio (A/B) of the average length in the normal line direction and the average length in the vertical direction against such normal line at the SiO₂ portion of the sputtering face was 0.6, and the average length in the normal line direction of the SiO₂ portion was 6µm.

### (Comparative Example 1)

ZnS powder having a purity of 4N (99.99%) or higher and SiO₂ powder were used, and SiO₂ was mixed with ZnS at a ratio of 20mol%.

This mixed powder was filled in a graphite die, and hot pressed under the conditions of an Ar atmosphere, a bearing of 150kg/cm², and a temperature of 1000°C.

The target obtained thereby had a relative density of 94%. Moreover, the ratio (A/B) of the average length in the normal line direction and the average length in the vertical direction against such normal line at the SiO₂ portion of the sputtering face was 1.1, and the average length in the normal line direction of the SiO₂ portion was 15µm.

### (Comparative Example 2)

ZnS powder having a purity of 4N (99.99%) or higher and SiO₂ powder were used, and SiO₂ was mixed with ZnS at a ratio of 20mol%.

This mixed powder was filled in a graphite die, and hot pressed under the conditions of an Ar atmosphere, a bearing of 300kg/cm², and a temperature of 1100°C.

The target obtained thereby had a relative density of 98%. Moreover, the ratio (A/B) of the average length in the normal line direction and the average length in the vertical direction against such normal line at the SiO₂ portion of the sputtering face was 1.0, and the average length in the normal line direction of the SiO₂ portion was 13µm.

### (Comparative Example 3)

ZnS powder having a purity of 4N (99.99%) or higher and SiO₂ powder were used, and SiO₂ was mixed with ZnS at a ratio of 20mol%.

This mixed powder was filled in a graphite die, and hot pressed under the conditions of an Ar atmosphere, a bearing of 300kg/cm², and a temperature of 1100°C.

The target obtained thereby had a relative density of 98%. Moreover, the ratio (A/B) of the average length in the normal line direction and the average length in the vertical direction against such normal line at the SiO₂ portion of the sputtering face was 1.1, and the average length in the normal line direction of the SiO₂ portion was 20µm.

Sputtering tests were conducted with the targets manufactured with foregoing Examples 1 to 3 and Comparative Examples 1 to 3. The sputtering condition was an input power of 5W/cm² and Ar gas pressure of 0.5Pa. The number of generated nodules and the roughness of the sputtering face were measured in the tests. The results are shown in Table 1.

As shown in Table 1, the number of generated nodules significantly decreased in the Examples in comparison to the Comparative Examples, and it is evident that the roughness of the sputtering face is also small. Thereby obtained is a sputtering target formed from a complex of chalcogenide and silicic oxide capable of reducing particles (dust emission) and nodules produced during sputtering, which is of high density and having minimal variation in quality, capable of improving mass productiveness, and, in particular, which is effective in forming a phase change optical disc protective film.

Moreover, there is a correlation between the ratio A/B of the length of the SiO₂ portion, and the generation of nodules and the surface roughness of the target, as illustrated in Fig. 1 and Fig. 2. Fig. 1 is a graph showing the correlation of A/B, which is the ratio of the generation rate of nodules and the length of the SiO₂ portion, and Fig. 2 is a graph showing the correlation of A/B, which is the ratio of the surface roughness Ra (µm) and the SiO₂ portion.

Therefore, by adjusting the ratio A/B of the length of the SiO₂ portion, the generation of nodules and the surface roughness of the target can be controlled.

**Table 1**

| | Density (%) | Average Length Ratio (A/B) of SiO₂ | Average Length (µm) in Normal Line Direction of SiO₂ | Nodule Generation Rate (number/cm²) | Sputtering Surface Roughness (Ra) |
|---|---|---|---|---|---|
| Example1 | 99 | 0.7 | 8 | 0.11 | 1.5 |
| Example2 | 98 | 0.9 | 10 | 0.20 | 2.3 |
| Example3 | 99.5 | 0.6 | 6 | 0.09 | 1.2 |
| Comparative Example 1 | 94 | 1.1 | 15 | 0.33 | 3.5 |
| Comparative Example 2 | 98 | 1.0 | 13 | 0.29 | 2.8 |
| Comparative Example 3 | 94 | 1.1 | 20 | 0.37 | 4.7 |
| A: Average length of silicic oxide in the normal line direction existing on the face within the range of -30°∼+30° against the normal line direction of the sputtering face | | | | | |
| B: Average length in the vertical direction against such normal line | | | | | |

### Effect of the Invention

The sputtering target for forming a phase change optical disc protective film formed from a complex of chalcogenide and silicic oxide according to the present invention is characterized in that it has a texture which becomes 0.3 ≤ A/B ≤ 0.95 when the length of silicic oxide in the normal line direction existing on the face against the normal line direction of the sputtering face is given as A and the length of silicic oxide existing within the range of -30°∼+30° in the vertical direction against the normal line is given as B. Thus, the present invention yields a significant effect in that it is capable of reducing particles (dust emission) and nodules produced during sputtering upon forming a film with sputtering, which is of high density and having minimal variation in quality, and capable of improving mass productiveness.

Thereby, high densification is enabled in a simple manner even upon miniaturizing the SiO₂ in the target, and a superior effect is yielded in that obtained is a sputtering target for optical disc protection film capable improving the evenness of deposition and increasing productivity without detriment to the characteristics as a protective film, as well as an optical recording medium having formed thereon the phase change optical disc protective film using such a target.

## Claims

1. A sputtering target for forming a phase change optical disc protective film formed from a complex of chalcogenide and silicic oxide, **characterized in that** said sputtering target for forming a phase change optical disc protective film has, at least in the erosion portion, a texture which becomes 0.3≤A/B≤0.95 when the average length of silicic oxide in the normal line direction existing on the face within the range of -30°∼+30° against the normal line direction of the sputtering face is given as A and the average length in the vertical direction against said normal line is given as B.

2. A sputtering target for forming a phase change optical disc protective film, **characterized in that** the average length A of silicic oxide in the normal line direction existing on the face within the range of -30°∼+30° against the normal line direction of the sputtering face is 0.1∼10µm.

3. A sputtering target for forming a phase change optical disc protective film according to claim 1, **characterized in that** the average length A of silicic oxide in the normal line direction existing on the face within the range of -30°∼+30° against the normal line direction of the sputtering face is 0.1∼10µm.

4. A sputtering target for forming a phase change optical disc protective film according to each of claims 1 to 3, **characterized in that** the chalcogenide contains zinc sulfide.

5. A sputtering target for forming a phase change optical disc protective film according to each of claims 1 to 4, **characterized in that** the composition of silicic oxide is 1 ∼ 50mol%.

6. A sputtering target for forming a phase change optical disc protective film according to each of claims 1 to 5, **characterized in that** the silicic oxide is silicon dioxide having a purity of 98% or higher.

7. A sputtering target for forming a phase change optical disc protective film according to each of claims 1 to 6, **characterized in that** the crystallization temperature of silicic oxide is within the range of 900∼1400°C.

8. A sputtering target for forming a phase change optical disc protective film according to each of claims 1 to 7, **characterized in that** the relative density is 97% or higher.

9. An optical recording medium having formed thereon a phase change optical disc protective film upon using the sputtering target according to claims 1 to 8.

## Amended claims

### Amended claims under Art. 19.1 PCT

**1.** A sputtering target for forming a phase change optical disc protective film formed from a complex of chalcogenide and silicic oxide, **characterized in that** said sputtering target for forming a phase change optical disc protective film has, at least in the erosion portion, a texture which becomes 0.3 ≤A/B≤0.95 when the average length of silicic oxide in the normal line direction existing on the face within the range of -30°∼+30° against the normal line direction of the sputtering face is given as A and the average length in the vertical direction against said normal line is given as B.

**2.** (Delete)

**3.** A sputtering target for forming a phase change optical disc protective film according to claim 1, **characterized in that** the average length A of silicic oxide in the normal line direction existing on the face within the range of -30°∼+30° against the normal line direction of the sputtering face is 0.1∼10µm.

**4.** A sputtering target for forming a phase change optical disc protective film according to each of claims 1, 3, **characterized in that** the chalcogenide contains zinc sulfide.

**5.** A sputtering target for forming a phase change optical disc protective film according to each of claims 1, 3 and 4, **characterized in that** the composition of silicic oxide is 1∼50mol%.

**6.** A sputtering target for forming a phase change optical disc protective film according to each of claims 1, 3 to 5, **characterized in that** the silicic oxide is silicon dioxide having a purity of 98% or higher.

**7.** A sputtering target for forming a phase change optical disc protective film according to each of claims 1, 3 to 6, **characterized in that** the crystallization temperature of silicic oxide is within the range of 900∼1400°C.

**8.** A sputtering target for forming a phase change optical disc protective film according to each of claims 1, 3 to 7, **characterized in that** the relative density is 97% or higher.

**9.** An optical recording medium having formed thereon a phase change optical disc protective film upon using the sputtering target according to claims 1, 3 to 8.
